# EUROPÄISCHE PATENTSCHRIFT

(11) **EP 0 565 664 B1**
(45) Veröffentlichungstag und Bekanntmachung des Hinweises auf die Patenterteilung: **05.08.1998**
(21) Anmeldenummer: 92921487.2
(22) Anmeldetag: 14.10.1992
(51) Int. Cl.: B29C 67/00, G03C 9/08, B29C 35/08

(54) **STEREOGRAFIE-VORRICHTUNG UND -VERFAHREN**
STEREOGRAPHIC EQUIPMENT AND METHOD
PROCEDE ET DISPOSITIF STEREOGRAPHIQUES

(30) Priorität: 16.10.1991 DE 4134265
(43) Veröffentlichungstag der Anmeldung: 20.10.1993
(73) Patentinhaber: EOS GmbH ELECTRO OPTICAL SYSTEMS, 82152 Planegg (DE)
(72) Erfinder: LANGER, Hans, J., D-8032 Gräfelfing (DE); OBERHOFER, Johann, D-8044 Unterschleissheim (DE)
(74) Vertreter: Prüfer, Lutz H., Dipl.-Phys.
(86) Internationale Anmeldenummer: EP9202376
(87) Internationale Veröffentlichungsnummer: WO9308506

(56) Entgegenhaltungen:
- EP-A- 393 676
- EP-A- 450 762
- WO-A-90/03255
- US-A- 3 030 917
- US-A- 3 735 733
- US-A- 4 331 099

## Beschreibung

Die Erfindung betrifft eine Vorrichtung zum Herstellen eines dreidimensionalen Objekts mittel Stereografie nach dem Oberbegriff des Anspruchs 1 bzw. ein Verfahren nach dem Oberbegriff des Anspruchs 10.

Das "Stereografie" genannte Verfahren ist beispielsweise in dem Artikel von Hideo Kodama, "Automatic method for fabricating a three-dimensional plastic model with photo-hardening polymer", Rev.Sci. Instrum. 52(11), Nov. 1981, Seiten 1770 bis 1773, beschrieben. Hierbei wird nach dem Verfestigen einer Schicht das Objekt abgesenkt, so daß sich auf der verfestigten Schicht eine flüssige Schicht eines Kunststoffmaterials bilden kann, die danach entsprechend der Form des herzustellenden Objekts durch Einwirkung elektromagnetischer Strahlung verfestigt wird. Allerdings kann die Dicke dieser zunächst flüssigen Schicht, die die Schichtdicke der nachfolgenden Schicht darstellt und damit die Herstellungsgenauigkeit maßgeblich beeinflußt, nicht exakt eingestellt werden bzw. hängt davon ab, wie schnell der flüssige Kunststoff beim Absenken auf die verfestigte Schicht strömen kann und eine eventuell überschüssige Menge wieder abströmen kann. Die Schichtdicke ist daher nicht genau definiert und zudem wird je nach Viskosität des Kunststoffs eine erhebliche Zeit zum Einstellen einer gewünschten Dicke benötigt.

Um diesen Zeitaufwand zu reduzieren, wird in der EP-A-0 171 069 vorgeschlagen, die verfestigte Schicht zunächst mehr als erforderlich abzusenken und danach wieder auf das endgültige Maß anzuheben. Damit läßt sich aber das Problem der ungenauen Schichtdicke nicht lösen. Hierzu wird in der EP-A-0 361 847 bzw. WO 90/03255, die den Oberbegriff des Anspruches 1 und den Oberbegriff des Anspruches 10 bildet, vorgeschlagen, mit einem Abstreifer überschüssiges Kunststoffmaterial abzuwischen und die Schichtdicke genau einzustellen. Es hat sich allerdings gezeigt, daß der bekannte Abstreifer insbesondere bei dünnen Schichten mit einer Schichtdicke von 0,1mm oder weniger lokale Störungen eher verstärkt. Insbesondere baut sich bei der Herstellung von Teilen mit geschlossenen Volumen, bei denen ein flüssiger Innenraum von einem festen Rand eingeschlossen ist, mit der Zeit ein schräger Rand auf, der schließlich sogar aus dem Bad herausragen kann und an dem der Abstreifer anstößt, sodaß dieser dejustiert oder sogar das Objekt oder der Abstreifer beschädigt wird. Gerade bei diesen Teilen mit geschlossenen Volumen hat es sich ferner gezeigt, daß die Oberfläche im Innenraum auch nach dem Abstreifen über den festen Rand hinaussteht und bei einer Veränderung der Randform nach innen daher keine exakte Schichtdicke erhalten wird. Schließlich ist es bei dieser bekannten Abstreifermethode in der Regel erforderlich, die Oberfläche der verfestigten Schicht über die Oberfläche des Kunststoffbades anzuheben, wodurch die Gefahr eines Einschlusses von Luftblasen in das Objekt entsteht.

Aus der EP-A-0 450 762 und der EP-A-0 393 676 ist jeweils eine Vorrichtung nach dem Oberbegriff des Anspruches 1 und ein Verfahren nach dem Oberbegriff des Anspruches 10 bekannt. Aus der US 4 331 099 ist eine Vorrichtung zum Aufbringen eines Lacks auf Druckplatten bekannt, bei der eine Abstreifklinge vorgesehen ist.

Es ist Aufgabe der Erfindung, die Herstellung des Objektes zu beschleunigen und die Genauigkeit und Qualität der Herstellung zu verbessern.

Die Aufgabe wird durch die in Anspruch 1 gekennzeichnete Vorrichtung bzw. das in Anspruch 10 gekennzeichnete Verfahren gelöst.

Weiterbildungen der Erfindung sind in den Unteransprüchen gekennzeichnet.

Die Erfindung wird im weiteren anhand eines Ausführungsbeispieles im Zusammenhang mit den Figuren beschrieben. Von den Figuren zeigen:
- Fig. 1: eine schematische Seitenansicht einer Ausführungsform der erfindungsgemäßen Vorrichtung;
- Fig. 2: eine vergrößerte Schnittdarstellung eines erfindungsgemäßen Abstreifers nach Detail X in Figur 1 in Ruhestellung; und
- Fig. 3: den Abstreifer nach Figur 2 im Betrieb.

Ein auf seiner Oberfläche offener Behälter 1 ist bis zu einem Niveau bzw. einer Oberfläche 2 mit einem lichthärtbaren, flüssigen Kunststoffmaterial 3 gefüllt. Im Behälter 1 befindet sich im Bereich des Kunststoffs 3 ein Träger 4 mit einer im wesentlichen ebenen und horizontalen Trägerplatte 5, die parallel zur Oberfläche 2 angeordnet ist und mittels einer schematisch angedeuteten Verschiebe- oder Höheneinstellvorrichtung 6 senkrecht zur Oberfläche 2 bzw. zur Trägerplatte 5 auf und ab verschoben und positioniert werden kann.

Auf der Trägerplatte 5 befindet sich das Objekt 7, das aus einer Mehrzahl von Schichten 7a, 7b, 7c und 7d, die sich jeweils parallel zur Oberfläche 2 und zur Trägerplatte 5 erstrecken, in der später beschriebenen Weise aufgebaut wird.

Eine Vorrichtung 8 zum Verfestigen der an die Oberfläche angrenzenden obersten Schicht 7d enthält eine Beleuchtungsvorrichtung 9 mit einer Lichtquelle, die über eine Optik 10 einen gebündelten Lichtstrahl 11 erzeugt. Etwa mittig oberhalb des Behälters 1 ist ein Umlenkspiegel 12 angeordnet, der kardanisch aufgehängt ist und von einer schematisch angedeuteten Schwenkvorrichtung 13 so geschwenkt werden kann, daß der auf den Spiegel 12 gerichtete Lichtstrahl 11 vom Spiegel 12 als reflektierter Lichtstrahl 14 an im wesentlichen jeder Stelle der Oberfläche 2 positioniert werden kann. Alternativ können in bekannter Weise auch zwei rotierende Spiegel, jeweils einer für eine Koordinatenrichtung, verwendet werden.

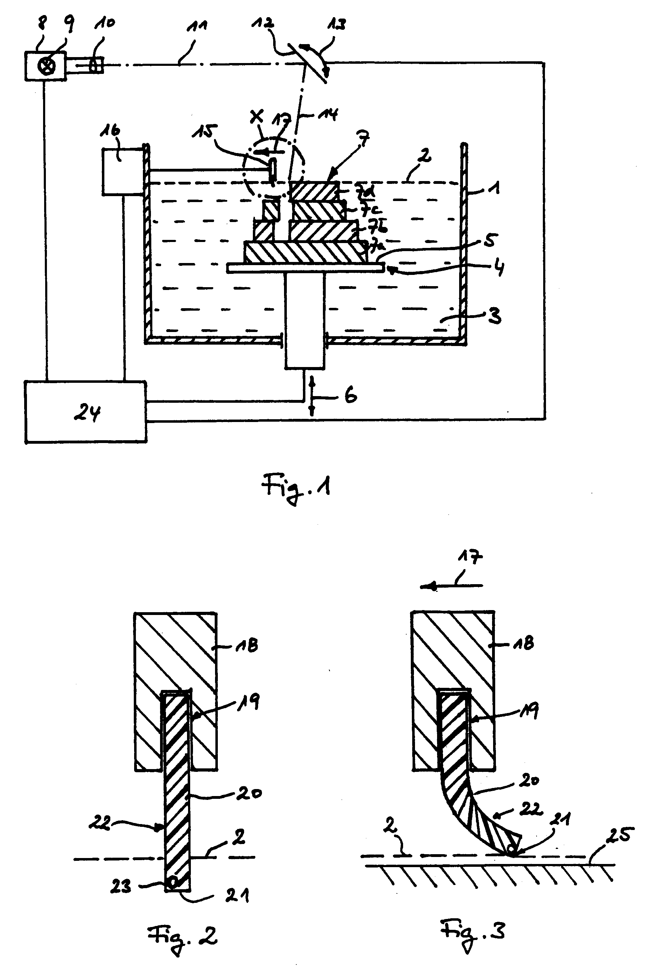

An der offenen Oberseite des Behälters 1 ist ein in Figur 1 schematisch angedeuteter Abstreifer 15 angeordnet, der sich im wesentlichen quer über den oben offenen Bereich des Behälters 1 erstreckt und mit einer Verschiebevorrichtung 16 zum Verschieben des Abstreifers 15 in einer horizontalen Ebene über die Oberfläche 2 in einer Richtung 17 im wesentlichen senkrecht zur Erstreckung des Abstreifers 15 gekoppelt ist. Der Abstreifer, der in Figur 2 im Querschnitt gezeigt ist, weist eine starre Schiene 18 auf, die auf ihrer der Oberfläche 2 zugewandten Unterseite eine Nut 19 aufweist, in die ein flexibles Element 20 eingesetzt ist. Das Element besitzt im dargestellten Fall die Form eines schmalen, hochkant am oberen Rand in die Nut 19 eingesetzten Rechteckprofils aus Gummi, dessen im wesentlichen horizontale Unterkante 21 im Bereich von 2 bis 10mm, vorzugsweise 3 bis 5mm unter der Unterseite der Schiene 18 liegt und in dem in Figur 2 gezeigten Ruhezustand um ein vorbestimmtes Maß, vorzugsweise etwa 0,5mm, in das Material 3 eintaucht. Es kann jedoch auch jedes andere Profil und jedes andere Material verwendet werden, das bei der seitlichen Verschiebung des Abstreifers in Richtung 17 eine seitliche Auslenkung der Unterkante 21 bzw. eine Verformung des freien Bereichs 22 des Elements 20 relativ zur Schiene 18 quer zur Verschieberichtung 21 erlaubt. Beispielsweise kann das Element 20 als eine Mehrzahl getrennter, nebeneinanderliegender flexibler Einzelelemente oder sogar als breiter Pinsel, bei dem die Einzelelemente die Form der einzelnen Pinselhaare annehmen, ausgebildet sein.

Nahe der Unterkante 21 ist im Element 20 ein Heizelement 23 integriert, das mit einer (nicht gezeigten) Spannungsversorgung zur geregelten Leistungszufuhr verbunden ist.

Die Verschiebevorrichtung 16 ist so ausgebildet, daß sie eine Verschiebung des Abstreifers 15 mit einer einstellbaren, veränderlichen Geschwindigkeit erlaubt.

Ein Rechner 24 ist mit der Beleuchtungsvorrichtung 9, mit der Schwenkvorrichtung 13, mit der Höheneinstellvorrichtung 6 und mit der Verschiebevorrichtung 16 zur Durchführung der im folgenden beschriebenen Schritte gekoppelt.

Im Betrieb werden zunächst im Rechner 24 aufgrund eines Konstruktionsprogramms oder dgl. Daten über die Form des Objekts 7 erstellt bzw. abgespeichert. Diese Daten werden für die Herstellung des Objekts 7 so aufbereitet, daß das Objekt in eine Vielzahl von horizontalen, im Vergleich zur Objektdimension dünnen Schichten mit einer Dicke von beispielsweise 0,1 (oder sogar weniger) bis 1mm zerlegt wird und die Formdaten für jede Schicht bereitgestellt werden.

Der Behälter wird dann mit Kunststoffmaterial 3 soweit gefüllt, daß die freie Oberfläche 2 des Kunststoffbades höher liegt als die Unterkante 21 des Abstreifers. Der Betrag, um den der Abstreifer 15 mit seinem flexiblen Element 20 in den Kunststoff eintaucht, wird dabei so gewählt, daß Unebenheiten der Oberfläche 2 im Betrieb, vor allem nach dem Absenken des Objekts nach der Verfestigung einer Schicht, sicher oberhalb der Unterkante 21 liegen. Die Eintauchtiefe hängt aber auch von der Viskosität des Materials 3 und der Elastizität des Elements 20 ab und beeinflußt auch die auszuführende Schichtdicke, sodaß der optimale Wert in jedem Einzelfall festzulegen ist. Praktisch liegt die Eintauchtiefe zwischen 0,2 und 1mm, vorzugsweise bei etwa 0,5mm.

Zur Herstellung der ersten Schicht 7a steuert nun der Rechner 24 die Höheneinstellvorrichtung 6 so, daß die Oberseite der Trägerplatte 5 auf eine der Dicke der Schicht 7a entsprechende vorbestimmte Höhe unterhalb der Oberfläche 2 bzw. unterhalb der Unterkante 21 gehoben wird. Diese Höhe kann, muß aber nicht so gewählt sein, daß zwischen der Oberseite der Trägerplatte 5 und dem vorher eingestellten Niveau der Oberfläche 2 ein der vorgesehenen Dicke der ersten Schicht 7a entsprechender Abstand vorliegt.

Aufgrund der Bewegung der Trägerplatte 5 ist jedoch die Oberfläche 2 nicht mehr eben, sondern beispielsweise aufgrund des vom Bereich oberhalb der Trägerplatte zur Seite hin abströmenden Kunststoffs 3 in der Mitte etwas höher. Um beschleunigt eine ebene Oberfläche 2 herzustellen, steuert daher der Rechner 24 die Verschiebevorrichtung 16 derart, daß diese den Abstreifer 15 mit einer vorbestimmten Geschwindigkeit horizontal über die Oberfläche 2 verschiebt. Dabei verformt sich in der in Figur 3 gezeigten Weise das flexible Element 20 auf die der Verschieberichtung abgewandte Seite und bewirkt damit sowohl ein Ausstreichen der Unebenheiten nach Art eines weichen Spachtels oder Pinsels als auch eine genaue Einstellung der Dicke der flüssigen Kunststoffschicht durch das Zusammenwirken der Oberfläche 25 und dem sich an diese in der in Figur 3 gezeigten Weise mehr oder weniger anschmiegenden Endbereich des Elements 20. Diese Dickeneinstellung erfolgt vorzugsweise durch Wahl der Verschiebegeschwindigkeit des Abstreifers 16, hängt aber ebenfalls von der Viskosität des Kunststoffs 3, der Elastizität des Elements 20 und dem Abstand zwischen der Oberfläche 25 der vorher verfestigten Schicht und der Unterkante 21 des Abstreifers 15 ab. Bei korrekter Einstellung dieser Parameter bildet sich direkt hinter dem Abstreifer 15 ein ebener Film flüssigen Materials 3. Hierzu kann im Rechner 24 eine entsprechende Relation in Form einer Tabelle oder Gleichung gespeichert sein, die empirisch ermittelt wird.

Zusätzlich kann beim Verschieben des Abstreifers 16 das Heizelement mit Spannung beaufschlagt werden, sodaß durch entsprechende lokale Erwärmung des Kunststoffs eine Steuerung und weiter beschleunigte Einstellung der gewünschten Schichtdicke erhalten wird.

Nach dieser Einstellung der Schichtdicke wird vom Rechner 24 die Beleuchtungsvorrichtung 9 und die Schwenkvorrichtung 13 so gesteuert, daß der reflektierte Lichtstrahl 14 auf den den im Rechner 24 erstellten und aufbereiteten Formdaten entsprechenden Stellen der flüssigen Kunststoffschicht auftrifft und dort in bekannter Weise eine Verfestigung durch Polymerisation bewirkt. Vorzugsweise kann dabei die Verschiebung des Abstreifers 15 und die Steuerung des Lichtstrahls 14 gleichzeitig derart erfolgen, daß der Lichtstrahl dem Abstreifer 15 nachgeführt wird und im Bereich unmittelbar hinter dem Abstreifer (in dessen Bewegungsrichtung gesehen) auf der Kunststoffschicht auftreffen, sodaß die Verfestigung bzw. Härtung der Kunststoffschicht unmittelbar nach der Einstellung der Schichtdicke erfolgt.

Nach der Herstellung der ersten Schicht 7a wird die Höheneinstellvorrichtung 6 vom Rechner um den Betrag der vorgesehen Dicke der nächsten Schicht 7b abgesenkt. Dadurch strömt flüssiger Kunststoff von den Seiten her über die verfestigten Bereiche der ersten Schicht 7a, sodaß sich zunächst keine gleichmäßige Schichtdicke einstellt. Dazu wird der Abstreifer 15 wiederum über die Oberfläche 2 bewegt und erzeugt aufgrund seines Einstreicheffektes wiederum eine flüssige Schicht konstanter, in Abhängigkeit der obengenannten Parameter vorgewählter Dicke. Gleichzeitig bewirkt der Abstreifer 15 in dem Fall, in dem die erste Schicht 7a einen geschlossenen, ein flüssiges Volumen einschließenden Rand bildet, daß die Oberfläche im Bereich des flüssigen Volumens geringfügig abgesenkt wird und nicht, wie bei starren Abstreifern festgestellt wurde, über die Oberfläche am Rand hervorsteht. Anschließend oder gleichzeitig mit dieser Schichtdickeneinstellung erfolgt in gleicher Weise wie bei der ersten Schicht 7a die Verfestigung.Die Herstellung der weiteren Schichten erfolgt dann analog.

Die Bewegung des Abstreifers 15 kann so erfolgen, daß der Abstreifer nach jedem Abstreifvorgang angehoben und wieder in die Ausgangslage auf einer Seite des Behälters 1 zurückbewegt wird. Alternativ kann die Verschieberichtung des Abstreifers 15 auch bei jeder aufeinanderfolgenden Schicht wechseln, sodaß die Anhebung und Rückführung in die Ausgangslage entfallen kann. In diesem Fall muß das flexible Element 20, beispielsweise wie das in den Figuren 2 und 3 gezeigte Rechteckprofil, natürlich eine Auslenkung bzw. Verformung nach beiden Seiten hin erlauben.

Eine besonders vorteilhafte Anwendung findet der Abstreifer erfindungsgemäß bei dem Verfahren nach Anspruch 10. Hierbei erfolgt die Verfestigung einer Schicht oder die Verbindung mit der darunterliegenden Schicht nicht gleichmäßig über die gesamte Ausdehnung der Schicht, sondern nur an definierten ersten Bereichen, sodaß zwischen diesen verfestigten ersten Bereichen jeweils zweite Bereiche mit flüssigem Material 3 verbleiben, die in einem nachfolgenden Arbeitsgang verfestigt werden. Hierdurch wird die Verformung des Objekts aufgrund der Schrumpfung des Materials beim Verfestigen vermindert. Allerdings führt dieses Verfahren zu einer unregelmäßigen Oberfläche. Diese Unregelmäßigkeit wird dadurch beseitigt, daß nach der Verfestigung der ersten Bereiche und vor der Verfestigung der zweiten Bereiche mittels des flexiblen Abstreifers ein dünner Film flüssigen Materials auf die bereichsweise verfestigte Schicht so aufge"strichen" wird, daß die Schichtdicke an den zweiten Bereichen etwa um die Schrumpfung des Materials größer ist als die bereits verfestigte Schichtdicke an den ersten Bereichen. Danach werden die zweiten Bereiche verfestigt, wobei deren Oberfläche aufgrund der Schrumpfung vorzugsweise auf dieselbe Höhe wie die Oberfläche der ersten Bereiche absinkt. Beispielsweise wird in einem ersten Arbeitsgang eine Schicht nur an jedem zweiten Bildpunkt rasterartig verfestigt. Aufgrund der Schrumpfung des Materials sinkt die Oberfläche 2 beispielsweise in den zweiten Bereichen zwischen diesen Punkten bzw. ersten Bereichen ab. Durch das Überstreichen mit dem Abstreifer 15 wird an diesen zweiten Bereichen die Oberfläche um das Schrumpfmaß über die verfestigte Oberfläche der ersten Bereiche angehoben und mittels einer gezielten Verfestigung nur an diesen zweiten Bereichen bzw. Punkten eine feste Schicht mit im wesentlichen ebener Oberfläche geschaffen. Selbstverständlich ist dieses Verfahren auch mit jeder beliebigen Zahl von aufeinanderfolgenden bereichsweisen Verfestigungen möglich.

Vielfältige Abwandlungen der beschriebenen Vorrichtung sind möglich. So kann beispielsweise anstelle des flüssigen Kunststoffs 3 auch Kunststoff- oder Metallpulver verwendet und durch Licht- oder Lasereinwirkung (Lasersintern) verfestigt werden. Die Verfestigung des Materials ist abhängig von dessen Eigenschaften auch durch andere Formen elektromagnetischer Strahlung oder Wärmestrahlung möglich. Anstatt die Trägerplatte 5 nach jeder Schicht abzusenken, kann auch das Niveau der Kunststoffoberfläche 2 zusammen mit dem Abstreifer 15 entsprechend angehoben werden.

Für den Abstreifer 15 sind alle zum Streichen geeigneten flexiblen Elemente wie beispielsweise eine Gummilippe oder eine Pinselleiste verwendbar. Möglich ist auch eine starre Schiene, die federnd um eine sich in Längsrichtung des Abstreifers 15 erstreckende Schwenkachse auslenkbar gelagert ist, sodaß sich die Flexibilität durch eine derartige federnde seitlich Auslenkung der Unterkante 21 ergibt. Allerdings ist dann der Einstreicheffekt nicht so deutlich wie bei einem in sich flexiblen Material, das sich mit kontinuierlicher Krümmung an die feste Oberfläche der vorhergehenden Schicht anschmiegt. Dieses Material kann in irgendeiner geeigneten Weise an der starren Schiene 18 befestigt sein, beispielsweise durch Ankleben an der Unter-, Vorder- oder Rückseite dieser Schiene.

Ferner kann der Abstreifer mit einer Antihaftbeschichtung oder aus einem Material mit schlechten Haftungseigenschaften am Kunststoffmaterial 3 gebildet sein. Schließlich ist es auch möglich, den aus Beleuchtungsvorrichtung 9 und Umlenkspiegel 12 bestehenden Scanner am Abstreifer 15 zu montieren oder mit der Verschiebevorrichtung 16 zu koppeln, sodaß der Lichtstrahl 11, 14 nur noch quer zu Verschieberichtung 17 ausgelenkt werden muß.

## Patentansprüche

1. Vorrichtung zum Herstellen eines Objekts mittels Stereografie, mit einem Behälter (1) zur Aufnahme eines Bades aus flüssigem oder pulverförmigem, durch Einwirkung von elektromagnetischer Strahlung verfestigbarem Material (3), einem Träger (4) zum Positionieren des Objekts relativ zur Oberfläche (2) des Bades und einer Vorrichtung (8) zum Verfestigen einer Schicht des Materials (3) an der Oberfläche mittels elektromagnetischer Strahlung
und einem entlang der Oberfläche (2) des Bades verschiebbaren Abstreifer (15), dadurch gekennzeichnet, daß der Abstreifer (15) an seinem der Oberfläche des Bades zugewandten unteren Ende zumindest bereichsweise in eine Richtung entgegen der Verschieberichtung (17) flexibel auslenkbar ausgebildet ist.

2. Vorrichtung nach Anspruch 1,
dadurch gekennzeichnet, daß der Abstreifer (15) als ein sich quer zur Verschieberichtung (17) erstreckendes Profil mit einem in und/oder gegen Verschieberichtung (17) flexibel auslenkbaren unteren Ende ausgebildet ist.

3. Vorrichtung nach Anspruch 1 oder 2,
dadurch gekennzeichnet, daß der Abstreifer (15) eine oberhalb der Oberfläche (2) des Bades angeordnete starre Schiene (18) aufweist, an der ein flexibles Element (20) derart befestigt ist, daß seine Unterkante um ein vorbestimmtes Maß unterhalb der Unterkante der Schiene (18) liegt.

4. Vorrichtung nach einem der Ansprüche 1 bis 3,
dadurch gekennzeichnet, daß der Abstreifer (15) bzw. das Element (20) in Form eines Streifens mit hochkant angeordneten schmalen Rechteckquerschnitt ausgebildet ist.

5. Vorrichtung nach einem der vorhergehenden Ansprüche,
dadurch gekennzeichnet, daß der Abstreifer (15) relativ zur Oberfläche (2) des Bades so angeordnet ist, daß in Ruhestellung des Abstreifers (15) seine Unterkante (21) um einen vorbestimmten Betrag in das Bad eintaucht.

6. Vorrichtung nach Anspruch 5,
dadurch gekennzeichnet, daß der Betrag zwischen 0,2 und 1 mm beträgt.

7. Vorrichtung nach Anspruch 6,
dadurch gekennzeichnet, daß der Betrag etwa 0,5mm beträgt.

8. Vorrichtung nach einem der vorhergehenden Ansprüche,
dadurch gekennzeichnet, daß an der dem Bad zugewandten Unterkante (21) des Abstreifers eine Heizvorrichtung (23) vorgesehen ist.

9. Vorrichtung nach einem der vorhergehenden Ansprüche,
dadurch gekennzeichnet, daß eine Vorrichtung (16) zum Verschieben des Abstreifers mit einer einstellbaren Geschwindigkeit vorgesehen ist.

10. Verfahren zum Herstellen eines Objekts mittels Stereografie, bei dem das Objekt in einem Bad aus flüssigem, mittels elektromagnetischer Strahlung verfestigbarem Material schichtweise verfestigt wird,
dadurch gekennzeichnet, daß für jede Schicht die folgenden Schritte durchgeführt werden:
a) zunächst werden erste Bereiche einer Schicht verfestigt, wobei zwischen diesen ersten Bereichen zweite Bereiche mit noch flüssigem Material verbleiben;
b) zumindest die zweiten Bereiche werden mit einem Film des flüssigen Materials derart überzogen, daß die Schichtdicke an den zweiten Bereichen im wesentlichen um das Schrumpfmaß größer ist als die Schichtdicke der verfestigten ersten Bereiche; und
c) danach wird die Schicht an den zweiten Bereichen verfestigt.

11. Verfahren nach Anspruch 10,
dadurch gekennzeichnet, daß der flüssige Film mittels des Abstreifers nach einem der Ansprüche 1 bis 9 aufgetragen wird.

## Claims

1. Apparatus for producing an object by means of stereography, having a tank (1) for receiving a bath of liquid or powdered material (3) which can be solidified by exposure to electromagnetic radiation, a support (4) for positioning the object in relation to the surface (2) of the bath and a device (8) for solidifying a layer of the material (3) on the surface by means of electromagnetic radiation and a stripper (15) which can be displaced along the surface (2) of the bath, characterized in that the stripper (15) is designed such that, at its lower end facing the surface of the bath, it can be deflected flexibly, at least in certain regions, in a direction counter to the displacing direction (17).

2. Apparatus according to Claim 1, characterized in that the stripper (15) is designed as a profile extending transversely with respect to the displacing direction (17), with a lower end which can be deflected flexibly in and/or counter to the displacing direction (17).

3. Apparatus according to Claim 1 or 2, characterized in that the stripper (15) has a rigid rail (18) which is arranged above the surface (2) of the bath and to which a flexible element (20) is fastened in such a way that its lower edge lies below the lower edge of the rail (18) by a predetermined amount.

4. Apparatus according to one of Claims 1 to 3, characterized in that the stripper (15) or the element (20) is designed in the form of a strip with a narrow rectangular cross-section arranged upright.

5. Apparatus according to one of the preceding claims, characterized in that the stripper (15) is arranged relative to the surface (2) of the bath in such a way that, in the position of rest of the stripper (15), its lower edge (21) is immersed in the bath by a predetermined amount.

6. Apparatus according to Claim 5, characterized in that the amount is between 0.2 and 1 mm.

7. Apparatus according to Claim 6, characterized in that the amount is about 0.5 mm.

8. Apparatus according to one of the preceding claims, characterized in that a heating device (23) is provided on the lower edge (21) of the stripper facing the bath.

9. Apparatus according to one of the preceding claims, characterized in that a device (16) for displacing the stripper at an adjustable speed is provided.

10. Method of producing an object by means of stereography, in which the object is solidified layer by layer in a bath of liquid material which can be solidified by means of electromagnetic radiation, characterized in that the following steps are carried out for each layer:
a) firstly, first regions of a layer are solidified, there remaining between these first regions second regions with still liquid material;
b) at least the second regions are coated with a film of the liquid material in such a way that the layer thickness at the second regions is greater than the layer thickness of the solidified first regions essentially by the amount of shrinkage; and
c) thereafter, the layer is solidified at the second regions.

11. Method according to Claim 10, characterized in that the liquid film is applied by means of the stripper according to one of Claims 1 to 9.

## Revendications

1. Dispositif de fabrication d'un objet par stéréographie, comprenant un récipient (1) contenant un bain d'une matière (3), liquide ou pulvérulente, durcissable sous l'effet d'un rayonnement électromagnétique, un support (4) destiné à positionner l'objet par rapport à la surface (2) du bain et un dispositif (8) utilisé pour durcir une couche de matière (3) sur la surface à l'aide d'un rayonnement électromagnétique, et une raclette (15) qui peut se déplacer le long de la surface (2) du bain, caractérisé en ce que la raclette (15) est conçue au niveau de son extrémité inférieure orientée vers la surface du bain de telle sorte qu'elle peut être déviée de manière flexible, au moins dans certaines zones, dans une direction opposée au sens du déplacement (17).

2. Dispositif selon la revendication 1, caractérisé en ce que la raclette (15) est conçue comme un profilé orienté transversalement par rapport au sens du déplacement (17) et comprenant une extrémité inférieure pouvant être déviée de manière flexible dans le sens de déplacement (17) et/ou à l'encontre de ce dernier.

3. Dispositif selon la revendication 1 ou 2, caractérisé en ce que la raclette (15) comporte un rail rigide (18) monté au-dessus de la surface (2) du bain, contre lequel rail est fixé un élément flexible (20) de telle sorte que son bord inférieur est situé à une distance donnée au-dessous du bord inférieur du rail (18).

4. Dispositif selon l'une quelconque des revendications 1 à 3, caractérisé en ce que la raclette (15) ou l'élément (20) est conçu sous forme d'une bande avec une section rectangulaire étroite montée sur chant.

5. Dispositif selon l'une quelconque des revendications précédentes, caractérisé en ce que la raclette (15) est disposée par rapport à la surface (2) du bain de telle sorte le bord inférieur (21) de la raclette (15), en position de repos, plonge sur une profondeur donnée dans le bain.

6. Dispositif selon la revendication 5, caractérisé en ce que la profondeur de plongée est comprise entre 0,2 et 1 mm.

7. Dispositif selon la revendication 6, caractérisé en ce que la profondeur de plongée est égale à 0,5 mm environ.

8. Dispositif selon l'une quelconque des revendications précédentes, caractérisé en ce qu'il est prévu de monter un dispositif de chauffage (23) sur le bord inférieur (21) de la raclette orienté vers le bain.

9. Dispositif selon l'une quelconque des revendications précédentes, caractérisé en ce qu'il est prévu de monter un dispositif (16) destiné à déplacer la raclette à une vitesse programmable.

10. Procédé de fabrication d'un objet par stéréographie, dans lequel l'objet est durci couche par couche dans un bain contenant une matière liquide durcissable par rayonnement électromagnétique, caractérisé en ce que les étapes suivantes sont exécutées pour chaque couche :
a) en premier lieu, le durcissement est exécuté dans les premières zones d'une couche, alors que des deuxièmes zones contenant encore la matière liquide subsistent entre ces premières zones durcies ;
b) au moins les deuxièmes zones sont revêtues d'un mince film de matière liquide, de telle sorte que l'épaisseur de la couche dans les deuxièmes zones est supérieure, d'une valeur pratiquement égale à la valeur de la contraction, à l'épaisseur des premières zones durcies ;
c) ensuite, le durcissement est exécuté dans les deuxièmes zones.

11. Procédé selon la revendication 10, caractérisé en ce que le film liquide est appliqué à l'aide de la raclette selon l'une des revendications 1 à 9.
